# EUROPEAN PATENT SPECIFICATION

(11) **EP 1 040 728 B1**
(45) Date of publication and mention of the grant of the patent: **27.07.2011**
(21) Application number: 98962994.4
(22) Date of filing: 08.12.1998
(51) Int. Cl.: H04S 7/00, H04N 5/60, G01R 19/04

(54) **PEAK TO PEAK SIGNAL DETECTOR FOR AUDIO SYSTEM**
SPITZENWERTERFASSUNGSSCHALTUNG FÜR EIN AUDIOSYSTEM
DETECTEUR DE SIGNAUX CRETE-A-CRETE POUR SYSTEME AUDIO

(30) Priority: 08.12.1997 US 67807 P
(43) Date of publication of application: 04.10.2000
(73) Proprietor: Thomson Licensing, 92130 Issy-les-Moulineaux (FR)
(72) Inventor: HOOVER, Alan, Anderson, Indianapolis, IN 46240 (US)
(74) Representative: Rossmanith, Manfred
(86) International application number: PCT/US1998/026140
(87) International publication number: WO 1999/030534

(56) References cited:
- EP-A- 0 415 779
- US-A- 3 979 670
- US-A- 4 109 198
- US-A- 4 528 501
- US-A- 5 614 851

## Description

### FIEL OF THE INVENTION

The present invention relates in general to the field of audio systems having signal detection devices for detecting audio signals and more particularly, to a peak-to-peak signal detector for detecting dual channel L+R stereo audio signals.

### BACKGROUND OF THE INVENTION

The broadcasting of multichannel or stereo sound programs for television in the United States is in accordance with the system adopted by the Broadcast Systems Television Committee (BTSC) of the Electronic Industries Association (EIA). This television multichannel sound system provides for the transmission of the sum of the left and right stereo audio information (L + R) in a main audio channel in the spectrum space of the television signal formerly occupied by the monophonic audio signal (mono). This was done so that new stereo signals would be compatible with existing monophonic television receivers. Television multichannel sound systems also provide for the transmission of the difference of the left and right stereo audio information (L-R), modulated onto a subcarrier.

The large multichannel sound systems employed in current consumer electronic audio units such as television receivers in combination with loud sound effects recorded on media including high-fidelity VHS video tapes and laser disks contribute to audio signals having wide dynamic range characteristics. Such system dynamic range capability is often an attractive feature in home theater audio/video systems currently on the market and generally contributes to the overall quality and enjoyment of the listener. However, while this may be true in general, sounds consisting of large amplitude transient signals can be disturbing and cause excessive noise. This may be most undesirable in certain instances, such as when children are sleeping. Not surprisingly, under these circumstances, it is desirable to include an automatic dynamic volume control compression system to limit the wide dynamic range performance over a range of audio signals. Accordingly, one must first accurately detect and track such positive or negative amplitude audio signals in order to perform such dynamic volume control processes.

A peak signal detector may be used to detect a peak amplitude associated with an audio signal and utilized to provide a detector voltage which may then be used to control a volume setting so as to limit the loudness indicative of a high amplitude transient signal. However, audio signals are often asymmetrical. Therefore, examination and detection of only one of the portions of an audio (AC) signal may result in detection of a peak that may be too small (or too large) and thus, not a correct representation of the transient signal amplitude to be detected. That is, if a positive peak detector is used to detect an ac audio signal, then detection of only positive transient signals would occur. For negative excursion transient signals, the positive peak detector would be unable to detect these negative transients, and hence allow the loud signal to be received and companded by the television receiver unit, resulting in an undesirably loud audio signal perceived by the listener. Use of precision rectifiers and amplifiers to detect signal amplitudes of both polarities may be employed to detect both positive and negative going transient ac signals. However, such rectifiers tend to be somewhat complex and require a relatively larger number of electronic components to implement the functions. This is an undesirable characteristic for a circuit which is to be included within a consumer electronic unit, such as a television receiver, in today's highly competitive market. For this reason, television manufacturers have been searching for a low cost and highly reliable alternative to accurately detect both positive and negative amplitude audio signals in order to perform dynamic volume control processing for limiting wide dynamic range audio.

US 5 614 851 describes a peak-to-peak detector. The peak-to-peak detector includes a clamp circuit followed by a peak-detect circuit. The clamp circuit receives an input signal having an alternating current (AC) component via an input coupling capacitor which outputs a voltage on a line to the peak-detect circuit. The clamp circuit bleeds current from the input coupling capacitor, and any slow drift in the DC level of the input voltage will be followed. The peak-detect circuit follows the voltage output by the coupling capacitor.

US 4 528 501 discloses a dual loudness meter for simultaneously indicating the apparent loudness of composite audio program material representing peak material or of persistent material. The loudness meter employs a first detector responsive to peak signals for instantaneously indicating the same as a singly actuated LED indicator in an array thereof displayed in accordance with the peak strength of the signal. A second detector for detects the persistence of the signal and displays the same as a bar graph on an LED display. The materials are colinearlly displayed and have dual upper extreme warning/operating indicator means. Specific circuits and time constants of response and decay are given as appropriate to the simultaneous reading, dual loudness meter.

### SUMMARY OF THE INVENTION

The present invention suggests a peak to peak detector as defined in the appended claims.

### BRIEF DESCRIPTION OF THE DRAWINGS

Figure 1 shows a circuit schematic diagram for a peak to peak detector for an audio system according to the present invention.
Figures 2A-C illustrate various waveforms resulting from the operation of the circuit of FIG. 1 and depicting the input L and R audio signal amplitudes and dc output voltages associated with the summed L and R audio signals.
Figure 3 depicts a block diagram of a volume control system employing the peak to peak detector circuit of FIG. 1 according to the present invention.

### DETAILED DESCRIPTION OF THE INVENTION

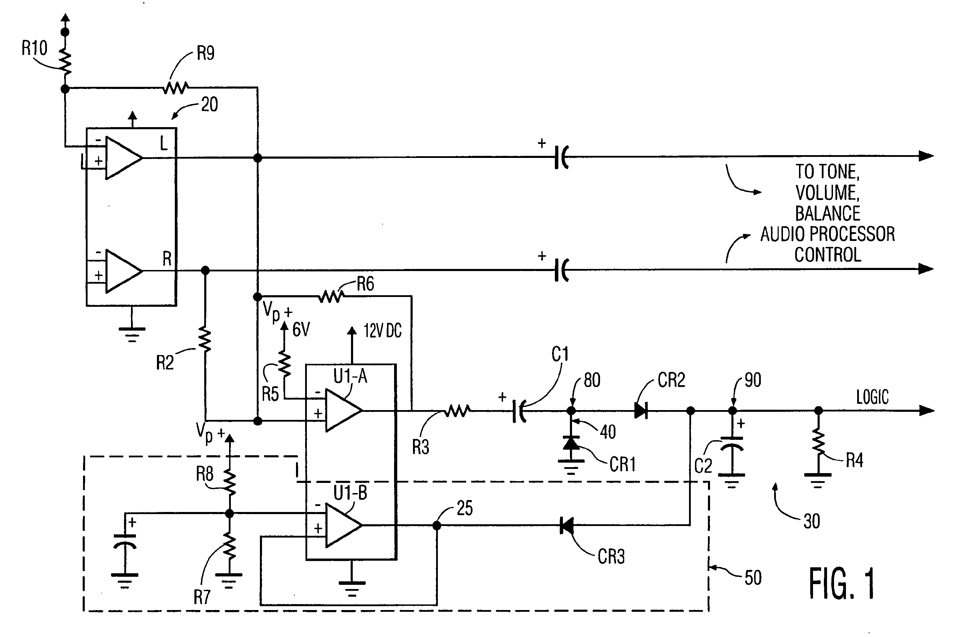

Figure 1 shows a detector circuit 10 according to the present invention for an audio compressor system of a television receiver, such as the MM 101 audio system manufactured by Thomson Consumer Electronics, Inc., the assignee herein. Note that throughout the drawings, like reference numerals are used to indicate like parts. Note further that, while FIG. 1 illustrates supply voltages and component values associated with resistive and capacitive circuit elements corresponding to a working embodiment of the detector circuit of the present invention, such values are merely exemplary, and it is understood that a person skilled in the art may make adjustments to the component values and supply voltages according to the requirements associated with a particular application.

As shown in FIG. 1, the detector circuit 10 is a peak to peak detector which forms a dc output signal 100 at output terminal 90 in response to L+R stereo audio signals components (i.e. AC signal) of a multichannel sound signal output from processor module 20. The amplitude of the dc output signal 100 is proportional to the sum of the peak-to-peak amplitudes of the L and R channel input audio signals. The peak-to-peak detector circuit operates to detect both positive and negative portions of the input L+R AC audio signal, since for many audio waveforms these are asymmetrical. Thus, detector circuit 10 is operative to detect both positive and negative going transients while using a minimal number of electronic components to provide an efficient, low cost detector. The detector output may be sampled by an audio system microprocessor for controlling the setting of the volume control of the audio system.

Still referring to FIG. 1, left (L) and right (R) stereo audio channels are applied to the inverting input or summing input (pin 2) of AC operational amplifier U1-A through resistors R1 and R2, respectively. The noninverting input (pin 3) of amplifier U1-A is coupled to supply voltage V_{c} via resistor R5. The output signal at output terminal 1 of amplifier U1-A consists of the inverted sum of signals L + R. Resistor R6 is coupled between the output terminal 1 and inverting terminal 2 of amplifier U1-A to provide a negative feedback to the amplifier for linear operation. The output terminal 1 is also coupled to a first terminal of resistor R3, whose second terminal is coupled to a positive terminal of capacitor C1. That is, resistor capacitor combination R3 and C1 are serially coupled to one another. Clamping diode CR1 has the anode electrode coupled to the negative terminal of capacitor C1 and the cathode electrode coupled to reference or ground potential. The (L + R) signal is passed through resistor R3 and capacitor C1, where it is clamped by diode CR1. The clamping circuit consisting of the RC combination of R3 and C1 and clamping diode CR1 operates to force the L + R negative portion of the signal to always operate at one diode drop below the reference potential (i.e. ground potential). As illustrated, the (L+R) signal at node 80 is now a variable dc signal, having substantially the same time vs. amplitude relationship as the original audio signal, as viewed on an oscilloscope, except for the dc offset. The signal at node 80 has a minimum voltage of approximately -0.6vdc (corresponding to one diode voltage drop) and a maximum voltage of the peak-to-peak amplitude of the L and R signal minus the aforementioned diode drop. This limits negative amplitude excursions associated with the variable dc voltage signal 40 to a predetermined minimal value of -0.6v.

Diode CR2 is coupled between the clamping circuit arrangement of diode CR1 at node 80 and the dc detector output at node 90 which forms a time constant circuit 30 comprising capacitor C2 and resistor R4 in parallel. The variable dc signal 40 at node 80 passes through diode CR2 and charges capacitor C2 when the voltage at node 80 exceeds the voltage at node 90 by one diode drop. The time constant associated with the charging of capacitor C2 is determined largely by the value of resistor R3. When the incoming audio signal L+R becomes zero amplitude, the capacitor begins to discharge through resistor R4 according to the time constant R2xC4. In order to respond rapidly to positive or negative transients in the L + R signal, the charge time of capacitor C2 should be considerably less than the discharge time of C2. Accordingly, the resistor values associated with R3 and R4 are chosen such that resistor R4 is considerably larger than the corresponding value associated with resistor R3. Such resistor values give the detector a "fast attack/slow decay" characteristic, typical of many audio detectors. While numerous resistor/capacitor combinations may be used according to particular system requirements, in the preferred embodiment, a 20:1 ratio of resistor values (R4 / R3) is preferred. Note that the discharge time of capacitor C2 is also determined by the input impedance of microprocessor 110 which is typically very high, relative to resistor R4. Thus, resistor R4 represents the dominant discharge impedance.

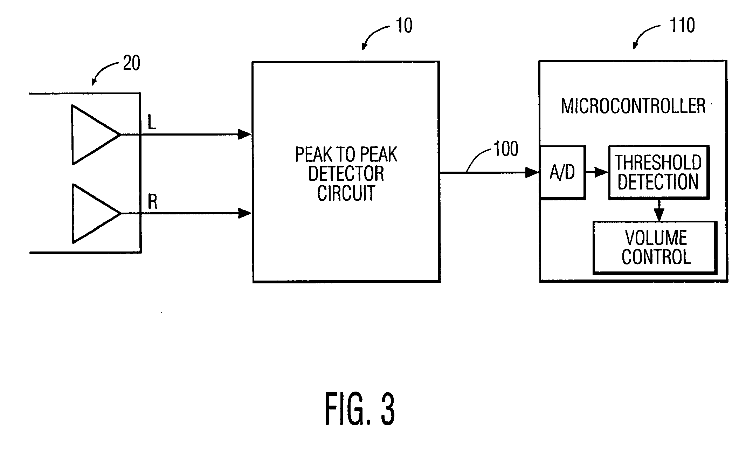

Referring to FIG. 1 in conjunction with FIG. 3, the limited fast-attack/slow-decay dc detector voltage 100 may be applied to the analog to digital converter (A-to-D) input of audio system microprocessor 110. Clamping circuit 50 (FIG.1) comprising unity gain operational amplifier U1-B and diode CR3 operates to limit or clamp the maximum amplitude of dc output signal 100 at a predetermined upper boundary. The voltage output at terminal 7 of amplifier U1-B is determined by the voltage at its noninverting input (pin 5). This voltage is generated as a result of R7 and R8 voltage divider for dividing the dc power supply voltage Vₚ between the two resistors. Capacitor C3 operating in parallel with resistor R7 acts as a filter. The output voltage of amplifier U1-B at pin 7 is therefore fixed according to its input voltage at pin 5, thus providing a constant voltage at node 25. Clamping diode CR3 has the anode electrode connected to output pin 7 and the cathode electrode connected to the anode of CR2 at detector output terminal 90. This arrangement operates to clamp or limit the detector output voltage at a maximum value corresponding to the voltage at pin 7 (i.e. node 25) plus the diode drop across diode CR3. That is, when the detector voltage at node 90 reaches the output voltage of amplifier U1-B plus one diode voltage drop, diode CR3 conducts. Since amplifier U1B is a low impedance device, the detector output is effectively limited. In the preferred embodiment, the detector output voltage amplitude is limited to approximately 5V by the clamping circuit consisting of the amplifier U1-B and related circuitry. In this embodiment, the output of U1-B is fixed at approximately 4.3V dc so that when the detector voltage at node 90 reaches the amplitude of 4.3V dc plus one diode drop, diode CR3 conducts. In this manner, clamping circuit 50 may operate to protect the A/D converter within microprocessor 110 which operates on 5 volts dc power supply. Since it may be undesirable for the A/D converter to accept an input signal exceeding the 5 volt operating voltage, the clamping circuit functions to limit the output detector voltage to a voltage not greater than the operating voltage of the processor operative to receive the output DC signal 100.

Referring to FIG. 3, the A/D converter samples the dc detector voltage signal 100 within a predetermined time interval range between 5-10 msec. The microprocessor then uses the sampled input to make processing decisions based on the sampled detector voltage amplitude. The processor uses these decisions to control the volume setting of the microcomputer-controlled volume control of the audio system, such as the MM101 audio system. That is, the processor compares the absolute amplitude of the sampled dc signal voltage 100 with a predetermined threshold and will decrease or adjust the volume control in proportion to the relative difference.

As previously mentioned, peak-to-peak detection is used in order to detect both the positive and negative portions of the ac audio signal, since for many audio waveforms the amplitudes are asymmetrical. Note that with respect to the detector circuit of Figure 1, if a positive going transient is output from amplifier U1-A at pin 1, the positive going transient will rapidly forward bias diode CR2. Similarly, capacitor C2 will charge rapidly if the positive going pulse has a high amplitude and hence, detection of the positive going transient pulse occurs in a relatively short time period. When capacitor C2 is fully discharged, if a negative going transient pulse is output at pin of amplifier U1-A, diode CR2 would not conduct as the voltage at node 80 does not exceed the voltage at node 90. Accordingly, the detector does not respond immediately to the negative going transient by charging capacitor C2. Instead, diode CR1 will conduct, and capacitor C1 begins to charge. Accordingly, detection of negative going transients requires an L + R waveform signal of sufficient period of time to charge up capacitor C1 to permit the detector output to produce a dc signal amplitude proportional to the peak to peak amplitude of the L + R signal.

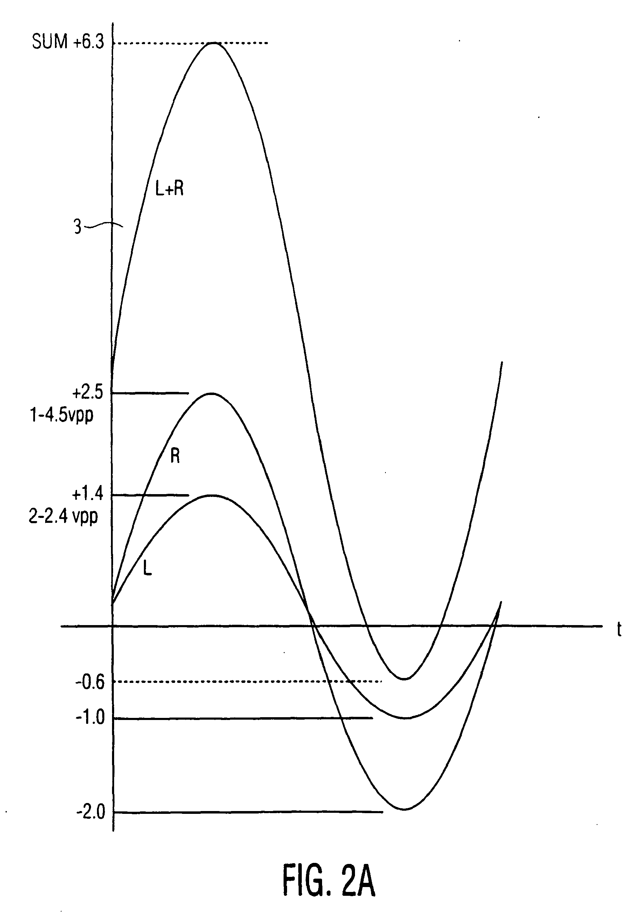

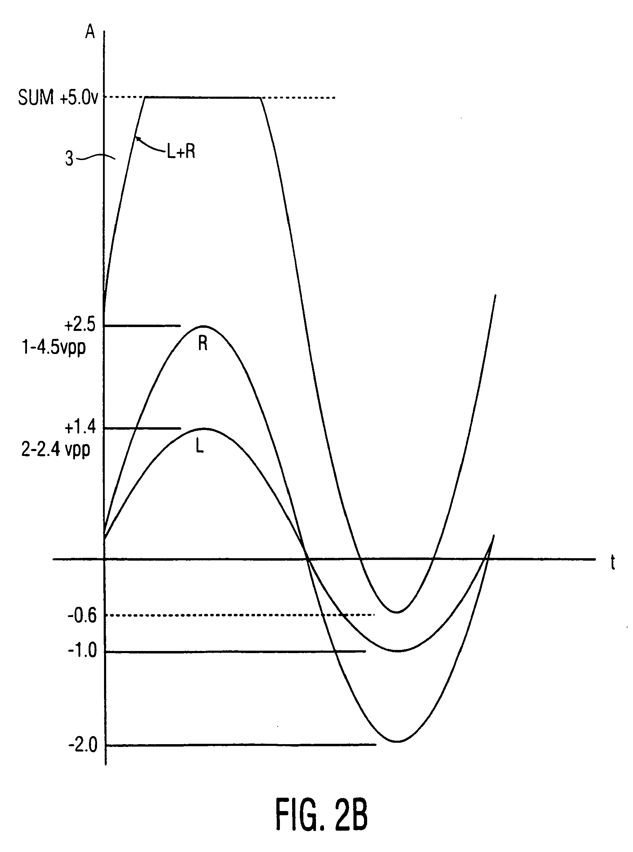

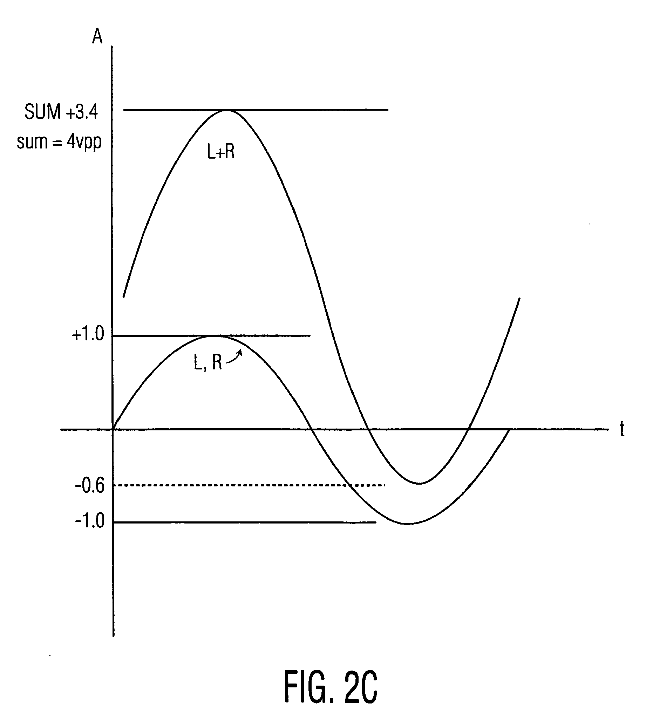

Figures 2A, 2B, and 2C represent exemplary waveform diagrams illustrative of the above-described detector processing. Referring now to Figure 2A in conjunction with Figure 1, waveform 1 depicts a 4.5 volt peak to peak signal with a 2.5 volt dc offset. Waveform 2 is a 2.4 volt peak to peak signal with a 0.2 dc offset. These signals are indicative of the right and left (R and L) stereo audio channel signals respectively, The variable dc signal output at node 80 (see Figure 1) is indicated by each of the waveforms depicted as waveform #3. This is the sum of the peak to peak voltages of waveforms #1 and #2. Waveform #3 of Figure 2A represents the dc variable voltage at node 80 with the limiting circuit 50 disabled. Therefore, the positive peak voltage of the sum is +6.3v while the negative peak voltage goes down to -0.6v. Figure 2B illustrates the same set of waveforms shown in Figure 2A, this time with the +5v limiting circuit 50 of Figure 1 enabled. In this case, the peak of the summed L+R signal waveform #3 is shown clipped at 5.0v peak with a 5.6v peak to peak voltage. The clamping circuit of CR1 operates to produce a minimum voltage level of -0.6v as also seen in Figure 2A.

Figure 2C illustrates a second pair of input waveforms indicative of the left and right stereo audio channel signals where each signal is an identical 2v peak to peak signal having no dc offset. The L + R summed signal waveform #3 is thus a 4v peak to peak signal, having peak values at +3.4v and -0.6v. While not illustrated in Figures 2A, 2B, 2C, one can ascertain that the dc amplitude values at node 90 are represented by the positive peak value of the summed waveforms #3 less the 0.6v diode drop across diode CR2.

Note that in operation within a volume control system of an audio device such as a television receiver, as shown in FIG. 3, the peak to peak detector outputs the dc voltage signal at an output terminal which is connectable to a processor such as a microcontroller having an A/D converter for converting the dc output signal to a series of digital samples. The processor operates in response to these digital samples to control the volume so as to eliminate the high amplitude transient signal characteristics associated with a loud audio L + R signal such as an explosion, a cannon shot, gun firing and the like. Compression of this signal occurs via software controls of the digitally controlled volume controller.

Note that the detector circuit described herein may be used in a variety of audio systems which include television receivers used in display devices (commonly known as television sets) as well as television receivers without a display device such as a VCR. It is also noted that some FM radios have the capability of receiving and reproducing television sound signals. As such, the peak to peak detector embodied in the present invention may be used in such FM radios as input to a processor for controlling the volume in response to the peak to peak amplitudes of the left and right stereo audio channel signals.

## Claims

1. A peak to peak detector circuit for use in an audio system, the peak to peak detector circuit comprising:
a first amplifier (U1-A) having an input terminal (2) for receiving left (L) and right (R) audio channel signals and an output terminal (1) for providing an L+R audio signal indicative of a sum of the left and right stereo audio channel signals, wherein said output terminal (1) is serially coupled to a resistor (R3) in series with a capacitor (C1) for generating a variable dc voltage having a time vs. amplitude relationship corresponding to said L+R audio signal;
a clamping diode (CR1) having an anode electrode coupled to a reference potential and a cathode electrode coupled to said capacitor (C1) to limit negative amplitude excursions associated with said variable dc voltage to a predetermined minimal value;
a rectifying diode (CR2) having an anode electrode coupled to said cathode electrode of said clamping diode (CR1), and a cathode electrode coupled to a second capacitor (C2) to charge said second capacitor (C2) responsive to an amplitude of said variable dc voltage to produce a dc output signal corresponding to a peak to peak amplitude of said L+R audio signal; and
a limiting circuit (50) responsive to a voltage value at said cathode electrode of said rectifying diode (CR2) for limiting said dc output signal to a maximum voltage value corresponding to a voltage not greater than an operating voltage of a processor (110) operative to receive said dc output signal.

2. The peak to peak detector circuit according to claim 1, wherein said limiting circuit (50) comprises a second amplifier (U1-B) coupled to a second clamping diode (CR3).

3. The peak to peak detector circuit according to claim 2, wherein said second amplifier is operative for generating a constant voltage at an output terminal (7), said second clamping diode (CR3) having a cathode electrode coupled to said output terminal (7) of said second amplifier (U1-B) and an anode electrode coupled to the cathode electrode of said rectifying diode (CR2), wherein said second clamping diode (CR3) conducts through said second amplifier (U1-B) to limit the maximum voltage value of said dc output signal when the voltage value at the cathode electrode of said rectifying diode (CR2) exceeds said output voltage of said second amplifier (U1-B) by a voltage drop across said second clamping diode (CR3).

4. The peak to peak detector circuit according to claim 1, wherein a charging time associated with said second capacitor (C2) is determined according to parametric values associated with said resistor (R3) and said second capacitor (C2).

## Patentansprüche

1. Schaltung zur Erfassung des Spitze-Spitze-werts zur Verwendung in einem Audiosystem, wobei die Schaltung zur Erfassung des Spitze-Spitze-Werts umfasst:
einen ersten Verstärker (U1-A) mit einem Eingangsanschluss (2) zum Empfangen eines linken (L) und eines rechten (R) Audiokanalsignals und mit einem Ausgangsanschluss (1) zum Bereitstellen eines L+R-Audiosignals, das eine Summe des linken und des rechten Stereo-Audiokanalsignals angibt, wobei der Ausgangsanschluss (1) mit einem Widerstand (R3) in Reihe mit einem Kondensator (C1) seriell geschaltet ist, um eine variable Gleichspannung mit einer dem L+R-Audiosignal entsprechenden Zeit-Amplituden-Beziehung zu erzeugen;
eine Klemmdiode (CR1) mit einer Anodenelektrode, die mit einem Referenzpotential gekoppelt ist, und mit einer Kathodenelektrode, die mit dem Kondensator (C1) gekoppelt ist, um negative Amplitudenauslenkungen, die der variablen Gleichspannung zugeordnet sind, auf einen vorgegebenen Minimalwert zu begrenzen;
eine Gleichrichterdiode (CR2) mit einer Anodenelektrode, die mit der Kathodenelektrode der Klemmdiode (CR1) gekoppelt ist, und mit einer Kathodenelektrode, die mit einem zweiten Kondensator (C2) gekoppelt ist, um den zweiten Kondensator (C2) in Reaktion auf eine Amplitude der variablen Gleichspannung zu laden, um ein Gleichstromausgangssignal zu erzeugen, das einer Spitze-Spitze-Amplitude des L+R-Audiosignals entspricht; und
eine Begrenzungsschaltung (50), die auf einen Spannungswert bei der Kathodenelektrode der Gleichrichterdiode (CR2) reagiert, um das Gleichstromausgangssignal auf einen maximalen Spannungswert zu begrenzen, der einer Spannung entspricht, die nicht höher als eine Betriebsspannung eines zum Empfangen des Gleichstromausgangssignals betreibbaren Prozessors (110) ist.

2. Schaltung zur Erfassung des Spitze-Spitze-Werts nach Anspruch 1, bei der die Begrenzungsschaltung (50) einen zweiten Verstärker (U1-B) umfasst, der mit einer zweiten Klemmdiode (CR3) gekoppelt ist.

3. Schaltung zur Erfassung des Spitze-Spitze-Werts nach Anspruch 2, bei der der zweite Verstärker zum Erzeugen einer konstanten Spannung bei einem Ausgangsanschluss (7) betreibbar ist, wobei die zweite Klemmdiode (CR3) eine Kathodenelektrode, die mit dem Ausgangsanschluss (7) des zweiten Verstärkers (U1-B) gekoppelt ist, und eine Anodenelektrode, die mit der Kathodenelektrode der Gleichrichterdiode (CR2) gekoppelt ist, aufweist, wobei die zweite Klemmdiode (CR3) über den zweiten Verstärker (U1-B) leitet, um den Maximalspannungswert des Gleichstromausgangssignals zu begrenzen, wenn der Spannungswert der Kathodenelektrode der Gleichrichterdiode (CR2) die Ausgangsspannung des zweiten Verstärkers (U1-B) um einen Spannungsabfall über die zweite Klemmdiode (CR3) übersteigt.

4. Schaltung zur Erfassung des Spitze-Spitze-Werts nach Anspruch 1, bei der eine dem zweiten Kondensator (C2) zugeordnete Ladezeit in Übereinstimmung mit Parameterwerten bestimmt wird, die dem Widerstand (R3) und dem zweiten Kondensator (C2) zugeordnet sind.

## Revendications

1. Circuit détecteur crête-à-crête destiné à une utilisation dans un système audio, le circuit détecteur crête-à-crête comprenant :
un premier amplificateur (U1-A) pourvu d'une borne d'entrée (2) permettant de recevoir des signaux de canaux audio gauche (G) et droite (D), et d'une borne de sortie (1) permettant d'émettre un signal audio G + D indicatif de la somme des signaux de canaux audio stéréo gauche et droite, où ladite borne de sortie (1) est couplée en série à une résistance (R3) en série avec un condensateur (C1) pour la génération d'une tension CC variable **caractérisée par** une relation temps/ amplitude correspondant audit signal audio G + D ;
une diode de niveau (CR1) pourvue d'une électrode anode couplée à un potentiel de référence et d'une électrode cathode couplée audit condensateur (C1) afin de limiter les excursions d'amplitudes négatives associées à ladite tension CC variable à une valeur minimale prédéfinie ;
une diode de redressement (CR2) pourvue d'une électrode anode couplée à ladite électrode cathode de ladite diode de niveau (CR1) et d'une électrode cathode couplée à un second condensateur (C2) pour charger ledit second condensateur (C2) réagissant à une amplitude de ladite tension CC variable, pour générer un signal de sortie CC correspondant à une amplitude crête-à-crête dudit signal audio G+D ; et
un circuit de limitation (50) réagissant à une valeur de tension à ladite électrode cathode de ladite diode de redressement (CR2) afin de limiter ledit signal de sortie CC à une valeur de tension maximale correspondant à une tension ne dépassant pas une tension de fonctionnement d'un processeur (110) prêt à recevoir ledit signal de sortie CC.

2. Le circuit détecteur crête-à-crête selon la revendication 1, dans lequel ledit circuit de limitation (50) comprend un second amplificateur (U1-B) couplé à une seconde diode de niveau (CR3).

3. Le circuit détecteur crête-à-crête selon la revendication 2, dans lequel ledit second amplificateur est prêt à générer une tension stable à une borne de sortie (7), ladite seconde diode de niveau (CR3) étant pourvue d'une électrode cathode couplée à ladite borne de sortie (7) dudit second amplificateur et d'une anode électrode couplée à l'électrode cathode de ladite diode de redressement (CR2), où ladite seconde diode de niveau (CR3) mène au second amplificateur (U1-B) pour limiter la valeur de tension maximale dudit signal de sortie CC lorsque la valeur de tension à l'électrode cathode de ladite diode de redressement (CR2) dépasse ladite tension de sortie dudit second amplificateur (U1-B) par une chute de tension à travers ladite seconde diode de niveau (CR3).

4. Le circuit détecteur crête-à-crête selon la revendication 1, dans lequel un temps de charge associé audit second condensateur (C2) est défini selon des valeurs paramétriques associées à ladite résistance (R3) et audit second condensateur (C2).
